# FASCICULE DE BREVET EUROPEEN

(11) **EP 2 351 031 B1**
(45) Date de publication et mention de la délivrance du brevet: **02.01.2019**
(21) Numéro de dépôt: 09768114.2
(22) Date de dépôt: 24.11.2009
(51) Int. Cl.: G11B 33/14, G11B 33/12, G11B 17/043, G06F 1/18, H05K 5/02

(54) **DISPOSITIF D'ACCUEIL D'UN DISQUE DUR ET EQUIPEMENT ELECTRONIQUE EQUIPE D'UN TEL DISPOSITIF**
FESTPLATTENLAUFWERK-GEHÄUSEEINRICHTUNG UND MIT EINER SOLCHEN EINRICHTUNG AUSGESTATTETE ELEKTRONISCHE VORRICHTUNG
HARD DRIVE HOUSING DEVICE AND ELECTRONIC APPARATUS PROVIDED WITH SUCH DEVICE

(30) Priorité: 28.11.2008 FR 0806695
(43) Date de publication de la demande: 03.08.2011
(73) Titulaire: SAGEMCOM BROADBAND SAS, 92500 Rueil Malmaison (FR)
(72) Inventeur: LEROUX, Gérard, 92500 Rueil-Malmaison (FR); SUSINI, Dominique, 92500 Rueil-Malmaison (FR); VENOM, Didier, 92500 Rueil-Malmaison (FR)
(74) Mandataire: Lavialle, Bruno François Stéphane
(86) Numéro de dépôt international: PCT/FR2009/001339
(87) Numéro de publication internationale: WO 2010/061075

(56) Documents cités:
- WO-A1-93/17471
- US-A- 5 451 168
- US-A- 5 747 735
- US-A- 6 135 792
- US-A1- 2004 223 421
- US-A1- 2005 106 937
- US-B1- 6 377 448

## Description

La présente invention concerne un dispositif d'accueil d'un disque dur et un équipement électronique équipé d'un tel dispositif. Un tel équipement est par exemple un équipement audiovisuel, comme un décodeur ou un lecteur optique de disque de type DVD, destiné à être relié à un téléviseur et comportant une fonctionnalité d'enregistrement de programmes télévisuels sur disque dur.

Un disque dur comprend généralement un boîtier dans lequel sont montés un disque magnétique, un module de lecture/écriture du disque magnétique et un moteur d'entraînement du disque. Le module de lecture/écriture et le moteur sont reliés à une unité de commande disposée dans le boîtier et reliée à un connecteur enfichable solidaire du boîtier. Comme le fonctionnement d'un tel disque dur est générateur de perturbations électromagnétiques, il est prévu sur le boîtier des surfaces de reprise de masse, usinées pour être parfaitement planes et lisses, dans chacune desquelles est ménagé un puits taraudé. L'agencement et le positionnement des surfaces de reprise de masse sont normalisés. Le disque dur est fixé dans l'équipement auquel il est destiné par des vis traversant un châssis électriquement conducteur de l'équipement et engagées dans les puits taraudés de telle manière qu'un contact électrique soit établi entre les surfaces de reprise de masse et le châssis conducteur lui-même relié à la masse. Le remplacement du disque dur contenu dans l'équipement par un autre disque dur nécessite l'intervention d'une personne qualifiée

Il a été envisagé de réaliser des équipements pourvus de disques durs extractibles. Le boîtier du disque dur est alors vissé dans un berceau pourvu de moyen de connexion au disque dur et à la partie électronique de l'équipement et accueilli de façon amovible dans le châssis de l'équipement. Ces équipements ne sont pas agencés pour permettre un remplacement du disque dur par un utilisateur n'ayant pas de connaissances techniques particulières.

Par ailleurs, il est connu du document US-A-6 135 792 un connecteur de carte électrique, ayant des moyens d'accueil d'une carte, comprenant un corps central à partir duquel s'étendent deux rails parallèles pour recevoir la carte à coulissement entre eux. Des éléments conducteurs de contact sont fixés aux rails pour être appliqués contre la carte et sont reliés à une masse.

Par l'invention on entend permettre à un tel utilisateur de remplacer le disque dur de son équipement par un disque dur acheté dans le commerce, ce disque dur étant classique et ne comportant pas d'aménagement particulier pour son interchangeabilité par l'utilisateur.

A cet effet, on prévoit, selon l'invention, un équipement pourvu de moyens d'accueil d'un disque dur comportant un boîtier portant un connecteur enfichable et ayant au moins une surface de reprise de masse, cet équipement comprenant un circuit imprimé portant un dispositif incluant un corps central à partir duquel s'étendent deux rails parallèles pour recevoir à coulissement des parties latérales du boîtier, ainsi qu'un connecteur comprenant des pattes soudées au circuit imprimé tout en étant agencé pour coopérer avec le connecteur enfichable du disque dur selon la direction de coulissement, et au moins un élément de contact comprenant une patte de fixation soudée au circuit imprimé, cet élément de contact étant électriquement conducteur et agencé pour être appliqué contre la surface de reprise de masse lors de la mise en place du disque dur dans l'équipement.

Ainsi, la mise en place du disque dur est réalisée simplement en engageant le boîtier du disque dur entre les rails du dispositif sans nécessiter une quelconque manipulation de vis de fixation. La connexion du disque dur au connecteur du dispositif et la mise à la masse du boîtier sont réalisées de façon transparente pour l'utilisateur par le simple engagement du disque dur entre les rails. Le retrait du disque dur est tout aussi simple.

Avantageusement, le connecteur et les éléments de contact sont fixés au circuit imprimé indépendamment les uns des autres et/ou par soudage.

De préférence, l'élément de contact comprend un support ayant une partie de fixation traversant une portion du rail et au moins une lame de contact qui s'étend dans le rail et qui est élastiquement déformable pour laisser passer le boîtier en étant appliquée sur celui-ci.

La lame de contact élastiquement déformable permet d'assurer un contact fiable avec la surface de reprise de masse même en cas de vibrations ou de légères variations d'épaisseurs des boîtiers des disques durs que le dispositif est destiné à accueillir.

Avantageusement, les rails ont une section en C comportant une âme et deux ailes et la partie de fixation traverse une des ailes du rail auquel l'élément de contact est fixé.

L'élément conducteur prend appui contre deux faces opposées de la partie latérale reçue dans le rail.

Avantageusement encore, la partie de fixation a une forme en harpon.

La forme en harpon assure une fixation mécanique.

Selon une caractéristique particulière, l'équipement comprend un levier coulissant d'éjection du disque dur, le levier d'éjection s'étend le long d'un des rails et a une première extrémité voisine d'une extrémité libre du rail et une deuxième extrémité, voisine du corps central, reliée audit rail ou au corps par une biellette agencée pour prendre appui sur une portion d'extrémité du boîtier du disque.

Ceci permet de faciliter le retrait du disque dur. De préférence, la course du levier est suffisante pour permettre le dégagement complet du connecteur du disque dur et du connecteur du dispositif.

L'invention a également pour objet un équipement comportant un châssis recevant une unité électronique comportant une carte à circuit imprimé sur laquelle est monté un dispositif de l'invention de telle manière que les rails aient une extrémité opposée au corps qui débouche à l'extérieur du châssis.

Avantageusement, les pattes de fixation sont électriquement connectées à une masse de la carte à circuit imprimé.

Les pattes de fixation exercent alors une fonction supplémentaire de conduction électrique pour relier les éléments conducteurs à la masse de l'équipement.

D'autres caractéristiques et avantages de l'invention ressortiront à la lecture de la description qui suit d'un mode de réalisation particulier non limitatif de l'invention.

Il sera fait référence aux dessins annexés, parmi lesquels :

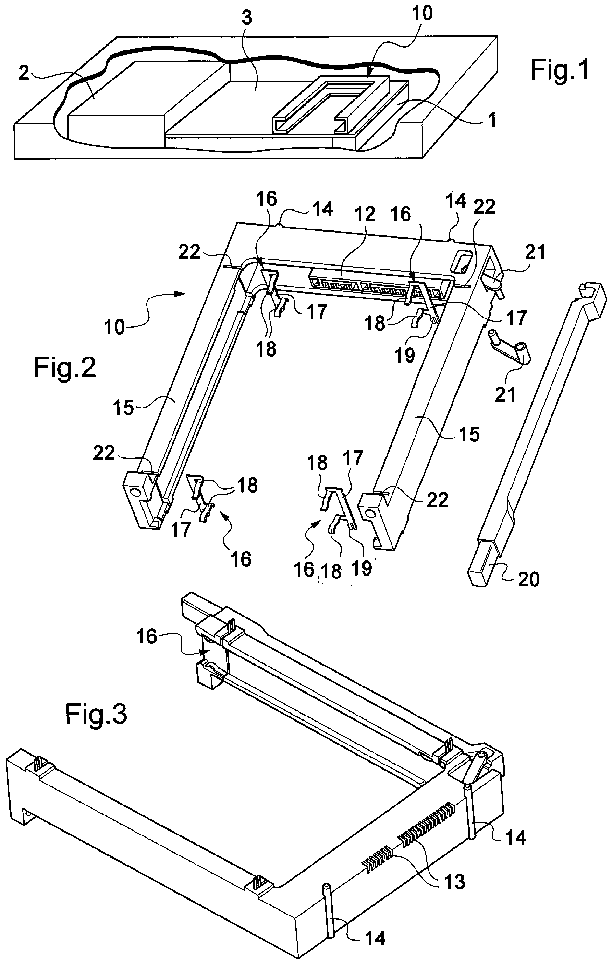

- la figure 1 est une vue schématique en perspective, avec écorché, d'un équipement conforme à l'invention,
- la figure 2 est une vue en perspective, de dessus et avec éclaté, d'un dispositif conforme à l'invention équipant cet équipement,
- la figure 3 est une vue en perspective, de dessous, de ce dispositif,

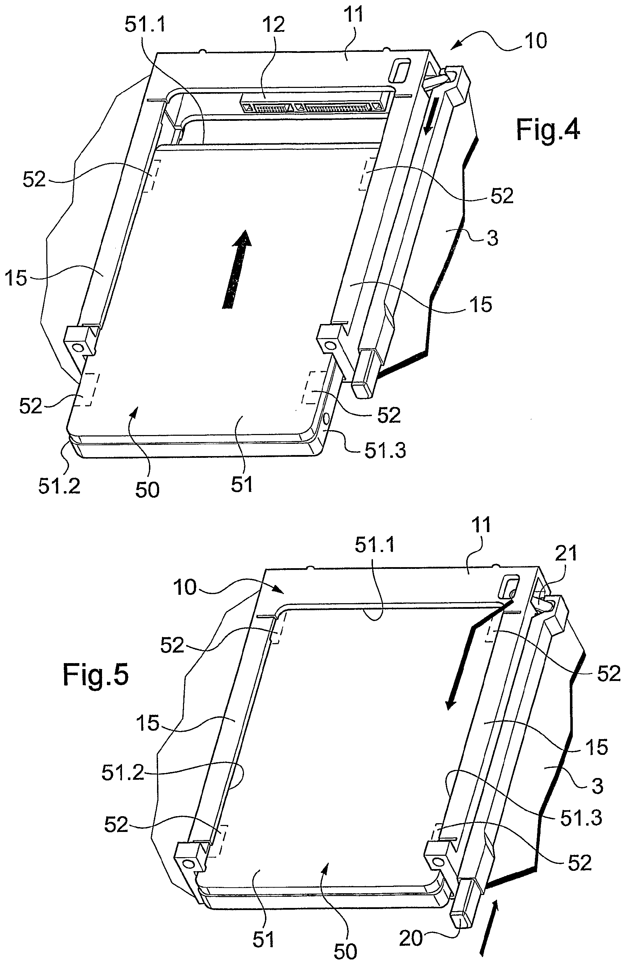

- les figures 4 et 5 sont des vues en perspective de ce dispositif montrant l'introduction d'un disque dur et un disque dur en place ;
- la figure 6 est une vue en perspective d'une variante de dispositif selon l'invention.

En référence aux figures, le dispositif conforme à l'invention comprend un châssis 1 recevant une unité électronique 2 comportant une carte à circuit imprimé 3 sur laquelle sont fixés des composants électroniques non représentés ici. L'équipement est par exemple un équipement audiovisuel, comme un décodeur ou un lecteur optique de disque de type DVD, destiné à être relié à un téléviseur et comportant une fonctionnalité d'enregistrement de programmes télévisuels sur disque dur. L'unité électronique 2 comprend ainsi par exemple un récepteur hertzien, une mémoire et un module de commande programmé pour afficher des menus permettant le réglage du récepteur, la programmation et la visualisation des enregistrements...

Pour l'enregistrement, l'équipement est équipé d'un disque dur 50, connu en lui-même, comportant un boîtier 51, de forme parallélépipédique, pourvu d'un connecteur externe enfichable ici de type SATA (non visible sur les figures) débouchant sur un côté 51.1 du boîtier 51 et de surfaces de reprise de masse 52. L'agencement et la position des surfaces de reprise de masse 52 est normalisée. Les surfaces de reprise de masse 52 sont disposées au voisinage des côtés 51.2, 51.3 du boîtier 51 qui sont perpendiculaire au côté 51.1 : quatre surfaces de reprise de masse 52 sont ménagées sur la face supérieure du boîtier 51 et quatre surfaces de reprise de masse 52 sont ménagées de manière correspondante sur la surface inférieure du boîtier 51. Ces surfaces de reprise de masse 52 se caractérisent en ce qu'elles sont électriquement conductrices et ont été usinées pour être planes et lisses de manière à permettre la réalisation d'un contact électrique fiable.

Le disque dur 50 est logé de façon amovible dans un dispositif d'accueil généralement désigné en 10 monté sur la carte à circuit imprimé 3. Le dispositif d'accueil comprend un corps central 11 ayant une section transversale en C avec une âme et deux ailes espacées pour recevoir entre elles le côté 51.1 du boîtier 51. Sur l'âme est monté un connecteur 12 ayant des pattes de liaison 13 passant par une ouverture de l'aile inférieure pour s'étendre en saillie à l'extérieur du corps et être raccordées à des plages de connexion du circuit de la carte à circuit imprimé 3. Les pattes de liaison peuvent être perpendiculaires ou parallèles aux ailes du corps central 11. Le dos de l'âme du corps central 11 est pourvu de nervures transversales formant des pions de guidage 14 permettant le positionnement du dispositif sur la carte à circuit imprimé 3.

Des extrémités du corps central 11, s'étendent, à l'opposé de l'âme de celui-ci, deux rails 15 parallèles l'un à l'autre et perpendiculaires au corps central 11. Les rails 15 ont une section en C avec une âme et deux ailes espacées pour recevoir entre elles un côté 51.2, 51.3 du boîtier 51. Le corps central 11 et les rails 15 délimitent un cadre en U qui vient chausser trois côtés consécutifs du boîtier 51. Le corps central 11 et les rails 15 sont ici formés en une seule pièce par injection et sont par exemple réalisés en polyester thermoplastique (de type PBT) chargé de fibre de verre.

Des éléments conducteurs 16 sont montés dans les ailes des rails 15 pour s'étendre en regard des surfaces de reprise de masse 52 lorsque le boîtier 51 est reçu entre les rails 15. Chaque élément conducteur 16 comprend un support 17 qui s'étend perpendiculairement aux ailes en étant noyé dans l'âme du rail 15 et qui a des extrémités dont sont solidaires des lames de contact 18 élastiquement déformables s'étendant au voisinage des ailes et parallèlement à celles-ci. Les lames de contact 18 sont incurvées de telle manière qu'à l'état de repos elles définissent entre elles une distance inférieure à l'épaisseur du boîtier 51 et à l'état déformé elles sont aplaties et définissent une distance égale à l'épaisseur du boîtier 51. Une patte de fixation 19 prolonge le support 17 pour traverser l'aile inférieur du rail 15 et s'étendre en saillie de celle-ci. La partie de fixation 19 a une forme en harpon et est engagée dans une fente 22 ménagée dans l'aile depuis un bord libre de celle-ci jusqu'à l'âme. De préférence, la patte de fixation 19 est reçue serrée dans la fente 22 pour assurer le maintien de l'élément conducteur 16 dans le rail 15 avant la fixation du dispositif à la carte à circuit intégré.

Le dispositif comprend un levier 20 d'éjection du disque dur. Le levier 20 est monté pour coulisser le long de l'âme d'un des rails 15 et a une première extrémité voisine d'une extrémité libre du rail 15 et une deuxième extrémité, voisine du corps central 11, reliée au corps central 11 par des biellettes 21 agencées pour prendre appui sur une portion d'extrémité du boîtier 51 du disque dur lorsque celui-ci est engagé dans le dispositif.

Le dispositif est clipsé dans un premier temps sur la carte à circuit imprimé 3, les pattes d'accrochage étant engagées dans des perçages ménagés au droit de plages de raccordement à la masse du circuit de la carte à circuit imprimé (la forme en harpon assure un maintien élastique du dispositif sur la carte à circuit imprimé). Les ailes inférieures des rails 15 sont appliquées contre la carte à circuit imprimé 3. Les pattes d'accrochage 19 sont ensuite soudées à la carte à circuit imprimé, de même que les pattes de liaison du connecteur 12 : le matériau constituant le corps central 11 et les rails 15 doit donc résister à la température de soudage.

Le dispositif est positionné dans l'équipement de telle manière que les extrémités libres des rails 15 et la première extrémité du levier 20 débouchent à l'extérieur du châssis pour être accessibles par l'opérateur de préférence sans nécessiter de démontage particulier.

Lors de la mise en place du disque dur, les lames de contact 18 sont élastiquement déformable pour laisser passer le boîtier en étant appliquées sur celui-ci. Le connecteur 12 coopère avec le connecteur enfichable du disque dur selon la direction de coulissement permettant ainsi la connexion des deux connecteurs.

Le retrait du disque dur est réalisé en actionnant le levier d'éjection.

Bien entendu, l'invention n'est pas limitée au mode de réalisation décrit mais englobe toute variante entrant dans le champ de l'invention telle que définie par les revendications.

En particulier, au lieu d'être élastiquement déformables, les éléments conducteurs peuvent être mécaniquement déplaçables entre une position inactive escamotée et une position de contact en saillie dans le rail par exemple au moyen d'une came en saillie dans le rail et déplacée par le boîtier lors de son introduction dans le dispositif.

Par ailleurs, le dispositif peut être positionné et fixé au circuit imprimé de façon complètement indépendante du connecteur, et/ou des éléments de contact assurant la reprise de masse.

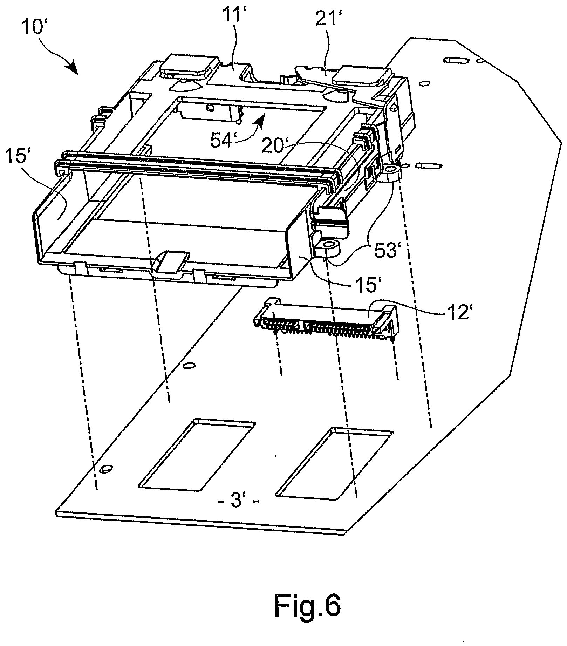

Cette variante représentée en figure 6 comporte également un dispositif d'accueil 10' formé d'un corps central 11' prolongé par deux rails parallèles 15', associé à un connecteur 12', tous deux destinés à être montés sur une carte de circuit imprimé 3'. Ces organes ont des formes générales analogues à celles des organes correspondants du mode de réalisation des autres figures.

Les éléments de contact, non représentés, peuvent être simplement soudés au circuit imprimé pour assurer conjointement leur fixation et leur connexion électrique, de sorte qu'il n'est alors pas nécessaire que ces éléments de contact comportent des extrémités en forme de harpon.

Le dispositif 10' peut quant à lui être équipé de pattes latérales 53' dédiées uniquement à sa fixation. Chaque patte se présente alors sous forme d'une languette métallique rigidement solidarisée à un rail 15' du corps du dispositif 10', et présente une extrémité en forme de harpon dépassant de la face inférieure de ce dispositif 10'.

Complémentairement, le dispositif 10' peut être pourvu d'un évidement 54' situé au niveau de son corps central 11', dans lequel se loge le connecteur 12'. Ce connecteur 12' est alors avantageusement lui aussi pourvu de pattes métalliques à extrémités en forme de harpons dédiées uniquement à sa fixation, tout en comportant également des pattes de liaison devant être raccordées par soudage à des plages de connexion du circuit de la carte à circuit imprimé 3'.

Le montage de l'ensemble peut alors consister à souder les éléments de contact, puis à fixer le connecteur 12', avant de fixer le dispositif 10'. La fixation du connecteur 12' peut consister à engager les extrémités de ses pattes de fixation dans des trous correspondants du circuit imprimé, et de manière analogue, la fixation du dispositif peut elle aussi consister à engager les extrémités de ses pattes de fixation en forme de harpons dans d'autres trous correspondants du circuit imprimé.

Une opération additionnelle de soudage peut éventuellement être prévue pour souder au circuit imprimé 3' les extrémités en forme de harpon des différentes pattes de fixation du connecteur et du dispositif.

Le levier d'éjection peut être omis, le retrait du disque dur se faisant en saisissant directement le boîtier, ou remplacé par un autre type de levier par exemple basculant.

En variante, les éléments conducteurs peuvent être fixés par tout moyen aux rails, par exemple par sertissage, clipsage, collage...

La liaison électrique des éléments conducteurs à la masse du circuit de la carte à circuit imprimé peut être réalisée par une portion dédiée indépendante de la patte d'accrochage.

## Revendications

1. Equipement pourvu de moyens d'accueil d'un élément extractible (50) comportant un boîtier (51) portant un connecteur enfichable et ayant au moins une surface de reprise de masse (52), cet équipement comprenant un circuit imprimé (3 ; 3') portant un dispositif (10 ; 10') incluant un corps central (11 ; 11') à partir duquel s'étendent deux rails (15 ; 15') parallèles pour recevoir à coulissement des parties latérales du boîtier, ainsi qu'un connecteur (12 ; 12') comprenant des pattes soudées au circuit imprimé (3 ; 3') tout en étant agencé pour coopérer avec le connecteur enfichable de l'élément extractible selon la direction de coulissement, et au moins un élément de contact (16) qui est fixé au dispositif et qui est électriquement conducteur et agencé pour être appliqué contre la surface de reprise de masse lors de la mise en place de l'élément extractible dans l'équipement, **caractérisé en ce que** l'élément de contact comprend une patte de fixation soudée au circuit imprimé (3 ; 3'), et un support (17) ayant une partie de fixation (19) traversant une portion d'un des rails (15) et deux lames de contact (18) qui s'étendent en regard l'une de l'autre dans ce rail et qui sont élastiquement déformables pour laisser passer le boîtier en étant appliquées de part et d'autre de celui-ci.

2. Equipement selon la revendication 1 dans lequel le dispositif (10'), le connecteur (12') et les éléments de contact sont fixés au circuit imprimé indépendamment les uns des autres.

3. Equipement selon la revendication 1 ou 2, dans lequel le dispositif (10 ; 10'), le connecteur (12 ; 12') et les éléments de contact sont fixés au circuit imprimé par soudage.

4. Equipement selon l'une des revendications précédentes, dans lequel les rails (15) ont une section en C comportant une âme et deux ailes et dans lequel la partie de fixation (19) traverse une des ailes du rail auquel l'élément de contact (16) est fixé.

5. Equipement selon l'une des revendications précédentes, dans lequel la partie de fixation (19) a une forme en harpon.

6. Equipement selon l'une des revendications précédentes, comprenant un levier (20) coulissant d'éjection de l'élément extractible, le levier d'éjection s'étendant le long d'un des rails (15) et ayant une première extrémité voisine d'une extrémité libre du rail et une deuxième extrémité, voisine du corps central (11), reliée audit rail ou au corps par une biellette (21) agencée pour prendre appui sur une portion d'extrémité du boîtier de l'élément extractible.

7. Equipement selon l'une des revendications précédentes, dans lequel le connecteur (12) possède des pattes de liaison à un circuit imprimé, qui s'étendent parallèlement ou perpendiculairement aux rails.

8. Equipement selon l'une des revendications précédentes, dans lequel les deux parties latérales (51.2, 51.3) du boîtier (51) sont pourvues sur deux faces opposées de deux surfaces de reprise de masse (52), dans lequel les rails (15) ont une section en C comportant une âme et deux ailes et sont pourvus chacun de deux éléments de contact (16) comprenant un support (17) qui s'étend perpendiculairement aux ailes et qui a des extrémités dont sont solidaires des lames de contact (18) s'étendant au voisinage des ailes et parallèlement à celles-ci, une patte de fixation (19) prolongeant le support et traversant une aile du rail.

9. Equipement selon la revendication 1, dans lequel le dispositif (10) est monté sur la carte à circuit imprimé (3) de telle manière que les rails (15) aient une extrémité opposée au corps central (11) qui débouche à l'extérieur d'un châssis.

10. Equipement selon la revendication 8, dans lequel les pattes de fixation (19) sont électriquement connectées à une masse de la carte à circuit imprimé.

11. Equipement selon la revendication 8, comprenant un levier (20) coulissant d'éjection de l'élément extractible, le levier d'éjection s'étendant le long d'un des rails (15) et ayant une première extrémité qui débouche à l'extérieur d'un châssis et une deuxième extrémité, voisine du corps central (11), reliée audit rail ou au corps par une biellette (21) agencée pour prendre appui sur une portion d'extrémité du boîtier de l'élément extractible.

## Patentansprüche

1. Einrichtung, die mit Aufnahmemitteln zur Aufnahme eines herausziehbaren Elements (50) versehen ist, das ein Gehäuse (51) umfasst, das einen Steckverbinder trägt und mindestens eine Masseanschlussfläche (52) hat, wobei diese Einrichtung eine Leiterplatte (3; 3') umfasst, die eine Vorrichtung (10; 10') trägt, die einen zentralen Körper (11; 11') einschließt, von dem sich zwei parallele Schienen (15; 15') erstrecken, um seitliche Teile des Gehäuses gleitend aufzunehmen, sowie einen Verbinder (12; 12'), der an die Leiterplatte (3; 3') geschweißte Laschen umfasst, während er so ausgebildet ist, dass er mit dem Steckverbinder des herausziehbaren Elements in Gleitrichtung zusammenarbeitet, und mindestens ein Kontaktelement (16), das an der Vorrichtung befestigt ist und das elektrisch leitend und so ausgebildet ist, dass es während des Platzierens des herausziehbaren Elements in der Einrichtung gegen die Masseanschlussfläche gedrückt wird, **dadurch gekennzeichnet, dass** das Kontaktelement eine an die Leiterplatte (3; 3') geschweißte Befestigungslasche umfasst, sowie einen Träger (17), der einen Befestigungsteil (19) hat, der einen Abschnitt einer der Schienen (15) durchsetzt, sowie zwei Kontaktzungen (18), die sich in dieser Schiene einander gegenüberliegend erstrecken und die elastisch verformbar sind, um das Gehäuse durchzulassen, während sie auf beiden Seiten desselben anliegen.

2. Einrichtung nach Anspruch 1, bei der die Vorrichtung (10'), der Verbinder (12') und die Kontaktelemente unabhängig voneinander an der Leiterplatte befestigt sind.

3. Einrichtung nach Anspruch 1 oder 2, bei der die Vorrichtung (10; 10'), der Verbinder (12; 12') und die Kontaktelemente an der Leiterplatte mittels Verschweißens befestigt sind.

4. Einrichtung nach einem der vorhergehenden Ansprüche, bei der die Schienen (15) einen C-förmigen Querschnitt haben, der einen Steg und zwei Schenkel umfasst, und bei der der Befestigungsteil (19) einen der Schenkel der Schiene durchsetzt, an dem das Kontaktelement (16) befestigt ist.

5. Einrichtung nach einem der vorhergehenden Ansprüche, bei der der Befestigungsteil (19) eine Hakenform hat.

6. Einrichtung nach einem der vorhergehenden Ansprüche, umfassend einen verschiebbaren Auswurfhebel (20) zum Auswerfen des herausziehbaren Elements, wobei sich der Auswurfhebel entlang einer der Schienen (15) erstreckt und ein erstes Ende in der Nähe eines freien Endes der Schiene hat, sowie ein zweites Ende, in der Nähe des zentralen Gehäuses (11), das mit der Schiene oder dem Körper über eine Stange (21) verbunden ist, die ausgebildet ist, um auf einem Endabschnitt des Gehäuses des herausziehbaren Element zur Anlage zu kommen.

7. Einrichtung nach einem der vorhergehenden Ansprüche, bei der der Verbinder (12) Laschen zur Verbindung mit einer Leiterplatte umfasst, die sich parallel oder senkrecht zu den Schienen erstrecken.

8. Einrichtung nach einem der vorhergehenden Ansprüche, bei der die beiden seitlichen Teile (51.2, 51.3) des Gehäuses (51) auf zwei entgegengesetzten Seiten mit Masseanschlussflächen (52) versehen sind, bei der die Schienen (15) einen C-förmigen Querschnitt haben, der einen Steg und zwei Schenkel umfasst, und die jeweils mit zwei Kontaktelementen (16) versehen sind, die einen Träger (17) umfassen, der sich senkrecht zu den Schenkeln erstreckt und der Enden hat, die mit den Kontaktzungen (18) verbunden sind, die sich in der Nähe der Schenkel und parallel zu denselben erstrecken, wobei eine Befestigungslasche (19) den Träger verlängert und einen Schenkel der Schiene durchsetzt.

9. Einrichtung nach Anspruch 1, bei der die Vorrichtung (10) auf der Leiterplatte (3) derart angebracht ist, dass die Schienen (15) ein dem zentralen Körper (11) entgegengesetztes Ende haben, das außerhalb eines Rahmens mündet.

10. Einrichtung nach Anspruch 8, bei der die Befestigungslaschen (19) elektrisch mit einer Masse der Leiterplatte verbunden sind.

11. Einrichtung nach Anspruch 8, umfassend einen verschiebbaren Auswurfhebel (20) zum Auswerfen des herausziehbaren Elements, wobei sich der Auswurfhebel entlang einer der Schienen (15) erstreckt und ein erstes Ende hat, das außerhalb eines Rahmens mündet, sowie in der Nähe des zentralen Körpers (11) ein zweites Ende, das mit der Schiene oder dem Körper über eine Stange (21) verbunden ist, die ausgebildet ist, um auf einem Endabschnitt des Gehäuses des herausziehbaren Elements zur Anlage zu kommen.

## Claims

1. Equipment provided with means for receiving an extractable element (50) including a casing (51) carrying a plug-in connector and having at least one grounding surface (52), this equipment comprising a printed circuit (3; 3') carrying a device (10; 10') including a central body (11; 11') from which extend two parallel rails (15; 15') for slidably receiving side portions of the casing and a connector (12; 12') having prongs soldered to the printed circuit (3; 3') while being adapted to co-operate with the plug-in connector of the extractable element in the sliding direction, and at least one contact element (16) that is fixed to the device and that is electrically conductive and adapted to be pressed against the grounding surface when the extractable element is being placed in the equipment, **characterized in that** the contact element comprises a fastener prong soldered to the printed circuit (3; 3') and a support (17) having a fastening portion (19) passing through a portion of one of the rails (15) and two contact blades (18) that face one another in this rail and that are elastically deformable to allow the casing to pass while being pressed against respective opposite sides thereof.

2. Equipment according to claim 1, wherein the device (10'), the connector (12') and the contact elements are fastened to the printed circuit independently of one another.

3. Equipment according to claim 1 or 2, wherein the device (10; 10'), the connector (12; 12') and the contact elements are fastened to the printed circuit by soldering.

4. Equipment according to any one of the preceding claims, wherein the rails (15) are of C section, comprising a web and two flanges, and wherein the fastening portion (19) passes through one of the flanges of the rail to which the contact element (16) is fastened.

5. Equipment according to any one of the preceding claims, wherein the fastening portion (19) is barb-shaped.

6. Equipment according to any one of the preceding claims, comprising a sliding lever (20) for ejecting the extractable element, the ejector lever extending along one of the rails (15) and having a first end adjacent a free end of the rail and a second end adjacent the central body (11) connected to said rail or to the body by a link (21) adapted to bear against an end portion of the casing of the extractable element.

7. Equipment according to any one of the preceding claims, wherein the connector (12) possesses prongs for connection to a printed circuit which extend parallel to or perpendicular to the rails.

8. Equipment according to any one of the preceding claims, wherein the two side portions (51.2; 51.3) of the casing (51) are provided on two opposite faces of two grounding surfaces (52) and wherein the rails (15) are of C section comprising a web and two flanges and are each provided with two contact elements (16) comprising a support (17) that extends perpendicularly to the flanges and has ends to which are secured contact blades (18) extending in the vicinity of the flanges and parallel thereto, a fastener prong (19) extending the support and passing through a flange of the rail.

9. Equipment according to claim 1, wherein the device (10) is mounted on the printed circuit card (3) in such a manner that the rails (15) have an end opposite the central body (11) that extends to the outside of a chassis.

10. Equipment according to claim 8, wherein the fastening prongs (19) are electrically connected to a ground of the printed circuit card.

11. Equipment according to claim 8, comprising a sliding lever (20) for ejecting the extractable element, the ejector lever extending along one of the rails (15) and having a first end that extends to the outside of a chassis and a second end adjacent the central body (11) connected to said rail or to the body by a link (21) adapted to bear on an end portion of the casing of the extractable element.
